Europäisches Patentamt

European Patent Office

Office européen des brevets

(19)

(11) Numéro de publication : **0 404 697 B1**

(12) # FASCICULE DE BREVET EUROPEEN

(45) Date de publication du fascicule du brevet :
**24.11.93 Bulletin 93/47**

(51) Int. Cl.⁵ : **H03F 1/34,** H03F 1/30,
H03F 3/19

(21) Numéro de dépôt : **90420289.2**

(22) Date de dépôt : **19.06.90**

(54) **Amplificateur large bande à gain constant et à impédance d'entrée déterminée à haute fréquence.**

(30) Priorité : **23.06.89 FR 8908567**

(43) Date de publication de la demande :
**27.12.90 Bulletin 90/52**

(45) Mention de la délivrance du brevet :
**24.11.93 Bulletin 93/47**

(84) Etats contractants désignés :
**AT DE FR GB IT NL**

(56) Documents cités :
**DE-A- 2 542 171**
**US-A- 3 379 988**
**PATENT ABSTRACTS OF JAPAN vol. 4, no.
175 (E-36)(657) 3 décembre 1980, & JP-A-55
121715 (PIONEER K.K.) 19 septembre 1980,
RADIO FERNSEHEN ELEKTRONIK. vol. 3, no.
2, février 1985, BERLIN DD page 131
"rfe-Kurzberichte, "Breitbandverstärker""**

(73) Titulaire : **SGS-THOMSON
MICROELECTRONICS S.A.
7, Avenue Gallièni
F-94250 Gentilly (FR)**

(72) Inventeur : **Perroud, Philippe
2, Impasse des Léchères
F-38240 Meylan (FR)**
Inventeur : **Jaffard, Jean-Luc
4 bis, Rue du Cotaire
F-38120 Saint Egrève (FR)**

(74) Mandataire : **de Beaumont, Michel
1bis, rue Champollion
F-38000 Grenoble (FR)**

EP 0 404 697 B1

## Description

La présente invention concerne un amplificateur de tension large bande, et plus particulièrement un amplificateur adapté à traiter des signaux provenant d'un élément de type inductif tel qu'une tête magnétique de lecture de magnétoscope.

La figure 1 représente de façon très schématique un tel élément inductif 1 connecté à la borne d'entrée 2 d'un amplificateur A qui amplifie la tension entre cette borne d'entrée 2 et une borne de sortie 3. Cet amplificateur pourra être un préamplificateur constituant l'étage d'entrée d'un circuit d'amplification comprenant d'autres éléments.

La figure 2 représente une réalisation classique d'un amplificateur A. Il comprend :
- une source d'alimentation 11 dont une première borne 12 est connectée à la borne de sortie par l'intermédiaire d'une résistance R1, et dont la deuxième borne 13 est reliée à la masse,
- un transistor bipolaire NPN T dont la base est connectée à la borne d'entrée 2, dont le collecteur est connecté à la borne de sortie 3 et dont l'émetteur est connecté à la masse, et
- une résistance R2 connectée entre le collecteur et la base du transistor T.

La source d'alimentation 11 sert à polariser le transistor T par l'intermédiaire des résistances R1 et R2.

Le gain en tension G1 de l'amplificateur A s'écrit
$$G1 = (\Delta V/VT)\{R1/[R1 + (R2/\beta)]\}, \quad (1)$$
où :
- $VT$ est un coefficient dépendant uniquement de la température,
- $\Delta V$ est la différence de tension entre la tension sur la borne de sortie et la tension sur la borne d'entrée, et
- $\beta$ est le gain du transistor T, égal au rapport entre le courant de collecteur $IC$ et le courant de base $IB$.

Avec des résistances R1 et R2 usuelles constantes, on voit que le gain G1 dépend de $\beta$. Or ce gain $\beta$ est susceptible de varier façon importante d'un transistor à l'autre. En effet, il dépend notamment de l'épaisseur de la base qui est très faible et que l'on ne peut pas déterminer et reproduire avec une très grande précision.

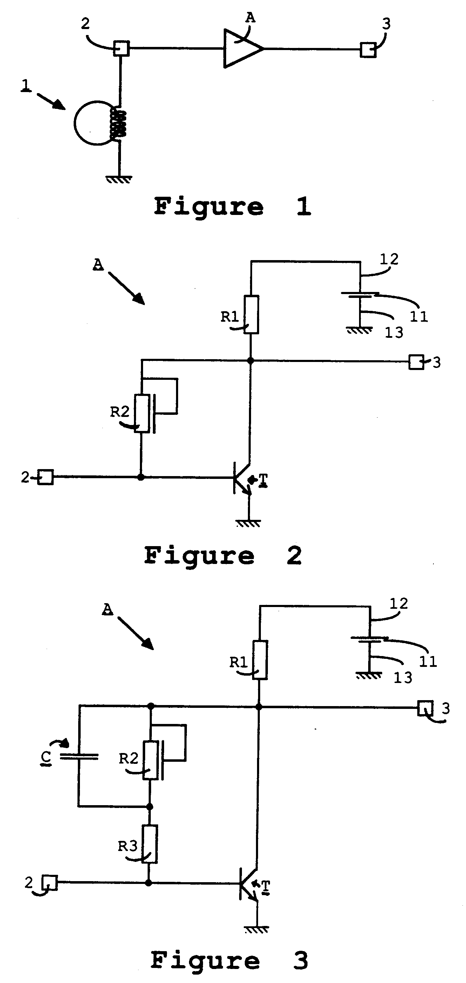

Il a alors été prévu dans le circuit de la figure 2 une résistance R2 liée par fabrication au gain $\beta$ du transistor. Pour fabriquer ce type de résistance, appelée résistance à base pincée, on réalise d'abord une diffusion (zone de base) en même temps que les régions de base des transistors. On forme ensuite une zone supplémentaire moins profonde qui est de la même nature et est réalisée en même temps que les régions d'émetteur des transistors. La valeur de la résistance dépend de l'épaisseur entre les limites inférieures des deux diffusions (on a réalisé un pincement), de la même façon que $\beta$ dépend de l'épaisseur entre la limite inférieure de la région de base et la limite inférieure de la région d'émetteur. En conséquence, la résistance R2 varie de façon proportionnelle à $\beta$. Le gain G1 de l'amplificateur ne dépend alors plus de $\beta$.

Toutefois, cette obtention d'un gain en tension constant entraîne que l'impédance d'entrée de l'amplificateur, Z1 (Z1 = R2.VT/$\Delta$V), qui est proportionnelle à R2 n'est plus déterminée de façon reproductible d'un amplificateur à un autre.

Cette non-reproductibilité de l'impédance d'entrée constitue un inconvénient rédhibitoire dans le cas d'une application à l'amplification de signaux en provenance d'une tête de lecture de magnétoscope. En effet, la fréquence des signaux appliqués sur la borne d'entrée de l'amplificateur est alors susceptible de varier dans une large bande de fréquence, par exemple entre 100 kHz et 10 MHz. L'impédance de la tête est alors largement variable et du même ordre de grandeur que l'impédance d'entrée du préamplificateur. Il en résulte que le gain effectif du préamplificateur n'est pas déterminé et n'est pas reproductible d'un lot de fabrication à un autre.

Un objet de la présente invention est de prévoir un amplificateur à large bande à gain en tension constant d'un amplificateur à l'autre et à impédance d'entrée déterminée et faible à haute fréquence.

Cet objet est atteint en prévoyant un amplificateur large bande entre une borne d'entrée et une borne de sortie comprenant un transistor bipolaire dont la base est connectée à la borne d'entrée, dont le collecteur est connecté à la borne de sortie qui est elle-même reliée à une source d'alimentation par une première résistance, et dont l'émetteur est à la masse ; une deuxième résistance dont la valeur varie en même temps que le gain en courant du transistor connectée entre la borne de sortie et la base du transistor; une capacité connectée en parallèle aux bornes de la deuxième résistance ; et une troisième résistance connectée entre la deuxième résistance et la base du transistor.

De préférence, la valeur de la troisième résistance est très inférieure à celle de la deuxième résistance, d'où il résulte que l'impédance de l'amplificateur est fixe et faible à haute fréquence.

Ces objets, caractéristiques et avantages ainsi que d'autres de la présente invention seront décrits plus en détail dans la description suivante d'un mode de réalisation particulier faite en relation avec les figures jointes parmi lesquelles :
- la figure 1, déjà décrite, représente de façon très schématique un amplificateur relié en entrée à un élément de type inductif ;
- la figure 2, déjà décrite, représente un amplificateur selon l'art antérieur ; et
- la figure 3 représente un amplificateur selon la présente invention.

La figure 3 représente un mode de réalisation d'un amplificateur selon la présente invention. Comme sur la figure 2, il comprend entre une borne d'entrée 2 et une borne de sortie 3 une source d'alimentation 11 reliée, d'une part, à la borne de sortie par l'intermédiaire d'une résistance R1, d'autre part, à la masse. Un transistor T a sa base connectée à la borne d'entrée, son collecteur connecté à la borne de sortie et son émetteur relié à la masse.

Une résistance R2 de type à bas pincée a également une première borne connectée à la borne de sortie. Cependant, une résistance R3 est rajoutée en série entre la deuxième borne de la résistance R2 et la base du transistor T. Une capacité C est aussi rajoutée en parallèle aux bornes de la résistance R2.

La source d'alimentation permet de polariser le transistor T par l'intermédiaire des résistances R1, R2 et R3. Le gain en tension G2 de cet amplificateur A s'écrit :

$$G2 = (\Delta V/VT)\{R1/[R1 + (R2 + R3)/\beta]\} \quad (2)$$

La résistance R2, qui est proportionnelle à $\beta$, est choisie importante par rapport à la résistance R3 ; les valeurs de ces résistances sont par exemple R2 = 150 k$\Omega$ et R3 = 30 k$\Omega$. Ainsi, on peut négliger dans la relation (2) R3 devant R2, et la relation (2) se ramène à la relation (1). Ainsi, le gain G2 est très peu dépendant de $\beta$.

En outre, l'impédance d'entrée Z2 de l'amplificateur en fonction de la fréquence $\omega$, est donnée par :

$$Z2(\omega) = (VT/\Delta V)[R3 + R2/(1 + R2C\omega)] \quad (3)$$

Pour des fréquences élevées, R2$\omega$ devient grand devant 1 et cette impédance d'entrée devient :

$$Z2(\omega) = (VT/\Delta V)[R3] ;$$

elle ne dépend plus de R2 mais seulement de R3.

Comme la résistance R3 a une valeur déterminée et reproductible, on a bien obtenu un préamplificateur de gain en tension constant (et donc à courant de bruit déterminée) grace au choix de R2 et à impédance d'entrée déterminée et reproductible à haute fréquence grâce au choix de R3.

A titre d'exemple numérique, pour une tête de lecture ayant une impédance susceptible de varier entre 50 $\Omega$ à basse fréquence et 1000 $\Omega$ à 10 MHz, on pourra choisir :

R1 = 1,2 k$\Omega$

R2 = 150 k$\Omega$,

R3 = 30 k$\Omega$,

C = 10 pF.

Alors, avec $\beta$ = 50, $\Delta V$ = 4,4V, et VT = 0,026 V, R2$\omega$ devient élevé devant 1 dès que la fréquence dépasse la centaine de kHz. La résistance d'entrée devient alors constante et de l'ordre de 200 $\Omega$ tandis que le gain en tension demeure sensiblement égal à 50.

La présente invention telle que décrite ci-dessus est susceptible de nombreuses variantes et modifications qui apparaîtront à l'homme de l'art. L'amplificateur peut par exemple être réalisé en utilisant une technologie à transistors bipolaires PNP à la place de transistors NPN. En outre, un transistor bipolaire supplémentaire peut être rajouté en série entre le collecteur du transistor T et la borne de sortie (le transistor T est cascodé) pour permettre le fonctionnement à haute fréquence.

## Revendications

1. Amplificateur large bande entre une borne d'entrée (2) et une borne de sortie (3) comprenant un transistor bipolaire (T) dont la base est connectée à la borne d'entrée, dont le collecteur est connecté à la borne de sortie qui est elle-même reliée à une source d'alimentation (11) par une première résistance (R1), et dont l'émetteur est à la masse, et une deuxième résistance (R2) dont la valeur varie en même temps que le gain en courant ($\beta$) du transistor connectée entre la borne de sortie et la base du transistor, caractérisé en ce qu'il comprend en outre :

   une capacité (C) connectée en parallèle aux bornes de le deuxième résistance, et

   une troisième résistance (R3) connectée entre la deuxième résistance et la base du transistor.

2. Amplificateur large bande selon la revendication 1, caractérisé en ce que la valeur de la troisième résistance (R3) est inférieure à celle de la deuxième résistance (R2), d'où il résulte que l'impédance de l'amplificateur est faible à haute fréquence.

3. Amplificateur large bande selon la revendication 1, caractérisé en ce que la deuxième résistance (R2) est du type à base pincée.

## Patentansprüche

1. Breitbandverstärker zwischen einem Eingangsanschluß (2) und einem Ausgangsanschluß (3), welcher einen bipolaren Transistor (T), dessen Basis mit dem Eingangsanschluß verbunden ist, dessen Kollektor mit dem Ausgangsanschluß verbunden ist, der seinerseits mit einer Stromversorgung (11) über einen ersten Widerstand (R1) verbunden ist, und dessen Emitter an Masse liegt, und einen zweiten Widerstand (R2) umfaßt, dessen Wert sich gleichzeitig mit dem Stromverstärkungsfaktor ($\beta$) des Transistors ändert und der zwischen dem Ausgangsanschluß und der Basis des Transistors geschaltet ist,

   dadurch **gekennzeichnet**, daß er weiterhin umfaßt:

   einen Kondensator (C), der zu den Anschlüssen des zweiten Widerstandes parallel geschaltet ist, und einen dritten Widerstand (R3), der zwischen dem zweiten Widerstand und der Basis des Transistors geschaltet ist.

2. Breitbandverstärker nach Anspruch 1, dadurch **gekennzeichnet**, daß der Wert des dritten Widerstands (R3) kleiner als der des zweiten Widerstands (R2) ist, woraus sich ergibt, daß die Impedanz des Verstärkers bei hohen Frequenzen gering ist.

3. Breitbandverstärker nach Anspruch 1, dadurch **gekennzeichnet**, daß der zweite Widerstand (R2) von der Art mit eingeschnürter Basis (résistance à base pincée) ist.

**Claims**

1. A broadband amplifier between an input terminal (2) and an output terminal (3) comprising a bipolar transistor (T), having a base connected to the input terminal, a collector connected to the output terminal which is in turn connected to a supply source (11) through a first resistor R1, and an emitter grounded, and a second resistor (R2), the value of which varies simultaneously with the current gain ($\beta$) of the transistor connected between the output terminal and the transistor base, characterized in that it further comprises:
   a capacitor (C) connected in parallel across the terminals of the second resistor, and
   a third resistor (R3) connected between the second resistor and the transistor base.

2. A broadband amplifier according to claim 1, characterized in that the value of the third resistor (R3) is lower than that of the second resistor (R2), whereby the amplifier impedance is low at high frequency.

3. A broadband amplifier according to claim 1, characterized in that the second resistor (R2) is of the pinched-base type.

**Figure 1**

**Figure 2**

**Figure 3**